# EUROPEAN PATENT APPLICATION

(11) **EP 3 518 417 A1**
(43) Date of publication of application: **31.07.2019**
(21) Application number: 19153999.8
(22) Date of filing: 28.01.2019
(51) Int. Cl.: H02P 29/024, H02P 21/22, G01R 31/34

(54) **REAL-TIME DETECTION OF MOTOR FAULTS WITH THREE-PHASE SINE DRIVE MOTORS**

(30) Priority: 26.01.2018 US 201815881278
(71) Applicant: Hamilton Sundstrand Corporation, Charlotte, NC 28217-4578 (US)
(72) Inventor: AVRITCH, Steven A., Bristol, CT 06010 (US); DICKIE, David F., Bloomfield, CT 06002 (US)
(74) Representative: Dehns

(57) **Abstract**

A method of detecting a fault in a sinusoidally controlled permanent magnet synchronous motor (PMSM) (16). The method includes receiving a first rotor reference frame current demand, the first rotor reference frame current demand based on a current control for the PMSM and receiving a first rotor reference frame current feedback, the first rotor reference frame current feedback corresponding to the first rotor reference frame current demand received. The method also includes computing a first error of the rotor reference frame current based on the first rotor reference frame current demand and the first rotor reference frame current feedback and identifying a fault of the sinusoidally controlled PMSM if the first error exceeds a first selected threshold for a first selected duration.

## Description

### BACKGROUND

The subject matter disclosed herein generally relates to a motors and motor control and, more particularly, to detecting faults in three-phase sine drive motors and the wiring connected to them.

Aircraft systems commonly include a variety of motor controlled systems. For example, actuation systems for control surfaces, aircraft components environmental control systems and the like. In some systems, such as actuation systems for control surfaces, detection of motor faults, or interconnect wiring faults, is very important to the proper operation of the system in the aircraft.

Conventional methods for detection of motor wiring faults have classically been limited to a non-real-time test signal injection, and phase-by-phase continuity checks, or limited, real-time, current monitoring, and summation (for a three-phase motor, the three phase currents should add to zero). While the phase-by-phase continuity check can be very thorough, it cannot be performed under operational conditions such as when a motor is being commanded in flight. The current sum monitor can be performed in flight, however, its fault detection capability is limited (i.e., phase-to-phase shorts and singular open phases cannot be detected).

Accordingly for at least the above discussed reasons, as well as others, there is a desire to provide improved control and fault detection methods for motors.

### BRIEF DESCRIPTION

According to one embodiment described herein is a method of detecting a fault in a sinusoidally driven or field oriented controlled (FOC) permanent magnet synchronous motor (PMSM). The method includes receiving a first rotor reference frame current demand, the first rotor reference frame current demand based on a current control for the PMSM and receiving a first rotor reference frame current feedback, the first rotor reference frame current feedback corresponding to the first rotor reference frame current demand received. The method also includes computing a first error of the rotor reference frame current based on the first rotor reference frame current demand and the first rotor reference frame current feedback and identifying a fault of the sinusoidally controlled PMSM if the first error exceeds a first selected threshold for a first selected duration.

In addition to one or more of the features described above, or as an alternative, further embodiments may include receiving a second rotor reference frame current demand, the second rotor reference frame current demand based on a current control for the PMSM, receiving a second rotor reference frame current feedback, the second rotor reference frame current feedback corresponding to the second rotor reference frame current demand received, computing a second error of the rotor reference frame current based on the second rotor reference frame current demand and the second rotor reference frame current feedback and identifying a fault of the sinusoidally driven PMSM if the second error exceeds a second selected threshold for a second selected duration.

In addition to one or more of the features described above, or as an alternative, further embodiments may include identifying a fault of the sinusoidally driven PMSM if the second error exceeds a second selected threshold for a second selected duration.

In addition to one or more of the features described above, or as an alternative, further embodiments may include that the first rotor reference frame current demand is the quadrature axis current (Iq).

In addition to one or more of the features described above, or as an alternative, further embodiments may include that the second rotor reference frame current demand is the direct axis current (Id).

In addition to one or more of the features described above, or as an alternative, further embodiments may include that the first selected threshold is based on at least the first rotor reference frame current demand.

In addition to one or more of the features described above, or as an alternative, further embodiments may include that the first selected threshold is based on a magnitude of the first rotor reference frame current demand.

In addition to one or more of the features described above, or as an alternative, further embodiments may include that the first selected duration is based on at least a characteristic of at least one component of a control system operably connected to the PMSM.

In addition to one or more of the features described above, or as an alternative, further embodiments may include that the first selected duration is based on a dynamic characteristic of the PMSM.

In addition to one or more of the features described above, or as an alternative, further embodiments may include that the second selected threshold is based on at least the second rotor reference frame current demand.

In addition to one or more of the features described above, or as an alternative, further embodiments may include that the second selected threshold is based on a magnitude of the second rotor reference frame current demand.

In addition to one or more of the features described above, or as an alternative, further embodiments may include that the second selected duration is based on a characteristic of at least one component of a control system operably connected to the PMSM.

In addition to one or more of the features described above, or as an alternative, further embodiments may include that the second selected threshold is based on a dynamic characteristic of the PMSM.

In addition to one or more of the features described above, or as an alternative, further embodiments may include controlling the PMSM based on the identifying of a fault of the sinusoidally driven PMSM.

Also described herein in an embodiment is a system for detecting a fault in a sinusoidally driven permanent magnet synchronous motor (PMSM). The system includes a sinusoidally driven PMSM and a controller operably connected to the PMSM. The controller is configured to receive a first rotor reference frame current demand, the first rotor reference frame current demand based on a current control for the PMSM, and receive a first rotor reference frame current feedback, the first rotor reference frame current feedback corresponding to the first rotor reference frame current demand received. The controller is also configured to compute a first error of the rotor reference frame current based on the first rotor reference frame current demand and the first rotor reference frame current feedback and identify a fault of the sinusoidally driven PMSM if the first error exceeds a first selected threshold for a first selected duration.

Also described herein in and embodiment is motor drive system configured for detecting a fault in a sinusoidally driven permanent magnet synchronous motor (PMSM). The system including an excitation source, a drive system operably connected to the excitation source and configured to provide motor command signals to the PMSM, and a controller operably connected to the PMSM. The controller is configured to receive a first rotor reference frame current demand, the first rotor reference frame current demand based on a current control for the PMSM and receive a first rotor reference frame current feedback, the first rotor reference frame current feedback corresponding to the first rotor reference frame current demand received. The controller is also configured to compute a first error of the rotor reference frame current based on the first rotor reference frame current demand and the first rotor reference frame current feedback and identify a fault of the sinusoidally driven PMSM if the first error exceeds a first selected threshold for a first selected duration.

The foregoing features and elements may be combined in various combinations without exclusivity, unless expressly indicated otherwise. It should be understood, however, that the following description and drawings are intended to be illustrative and explanatory in nature and non-limiting.

### BRIEF DESCRIPTION OF THE DRAWINGS

The foregoing and other features, and advantages of the present disclosure are apparent from the following detailed description taken in conjunction with the accompanying drawings in which:
FIG. 1 depicts a high level block diagram of motor drive system in accordance with one or more embodiments;
FIG. 2 depicts a more detailed block diagram of a control system and processes for a motor in accordance with one or more embodiments;
FIG. 3 depicts a more detailed block diagram of a fault detection function of the control system for a motor in accordance with one or more embodiments; and
FIG.4 is a flowchart of a method of detecting faults in a permanent magnet motor in accordance with one or more embodiments.

### DETAILED DESCRIPTION

Faults in an electric machine can occur for numerous reasons, including mechanical vibration, thermal cycling, thermal shock, manufacturing defects and improper maintenance. Applications of permanent magnet synchronous machines (PMSMs) are proliferating due to power density, efficiency gains, and simplicity in control algorithms. Field Oriented Control (FOC) is one control algorithm applied towards the control of PMSMs due to simplicity. However even with FOC some faults can impact performance, result in reductions in torque or force, or in some instances complete loss of functionality. Some typical faults that can occur in a PMSM drive system include winding failures, open circuits in the motor windings or wiring harness, short circuits of the motor windings internally, to each other, or to ground, and mechanical faults. A winding short in a rotating PMSM can result in induced voltages generating a current flow in a low resistance path. Currents beyond the rated current for the winding can then circulate in the loop of the conductor even at low speeds due to low resistance. Exceeding the rated current of the winding can cause overheating of the machine and can lead to potentially harmful circumstances. The rapid detection of such a winding fault will prevent damage to the machine, the drive electronics, and other equipment.

Embodiments described herein are directed to a monitoring mechanism and methodology that can detect motor phase open circuits and short circuits to ground. In one embodiment, the methods can also detect difficult to detect phase-to-phase short circuits within the motor windings or harness wiring. The described embodiments leverage the fact that the motor winding faults, under most conditions, result in larger than normal errors between commanded and actual quadrature current (Iq) and direct (Id) current feedback signals. The described embodiments incorporate a fault detection mechanism with a time based persistence on the Iq and Id error. Thus, providing the ability to detect motor winding faults while operating or even commanded to stop and thereby facilitating enhanced failure/fault detection capability in operation, and particularly flight operations).

For the purposes of promoting an understanding of the principles of the present disclosure, reference will now be made to the embodiments illustrated in the drawings, and specific language will be used to describe the same. It will nevertheless be understood that no limitation of the scope of this disclosure is thereby intended. The following description is merely illustrative in nature and is not intended to limit the present disclosure, its application or uses. It should be understood that throughout the drawings, corresponding reference numerals indicate like or corresponding parts and features. As used herein, the term controller refers to processing circuitry that may include an application specific integrated circuit (ASIC), an electronic circuit, an electronic processor (shared, dedicated, or group) and memory that executes one or more software or firmware programs, a combinational logic circuit, and/or other suitable interfaces and components that provide the described functionality.

Additionally, the term "exemplary" is used herein to mean "serving as an example, instance or illustration." Any embodiment or design described herein as "exemplary" is not necessarily to be construed as preferred or advantageous over other embodiments or designs. The terms "at least one" and "one or more" are understood to include any integer number greater than or equal to one, i.e. one, two, three, four, etc. The terms "a plurality" are understood to include any integer number greater than or equal to two, i.e. two, three, four, five, etc. The term "connection" can include an indirect "connection" and a direct "connection".

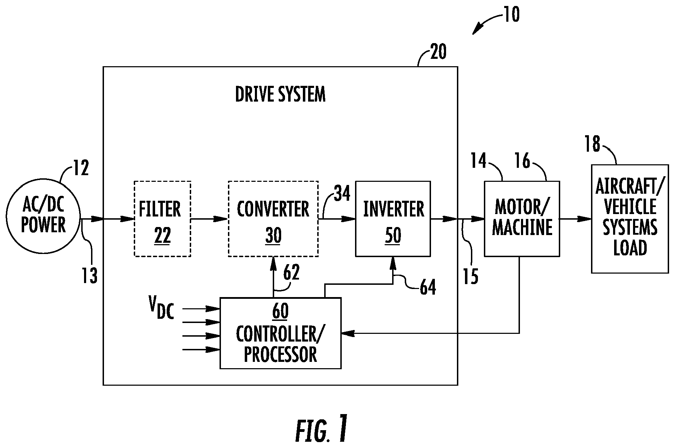

FIG. 1 is a block diagram of components of a power system 10 as may be employed to power one or more systems or loads 18. The power system 10 is described with respect to an aircraft power system, however application to any system where a three phase or motor drive is employed may be envisioned. Power system 10 includes a source of AC/DC power 12, such as an electrical main line, (e.g., 115/230 volt AC 400 Hz, 3-phase), power bus, DC power bus, battery and the like. The AC/DC power 12 is provided to a drive system 20. The drive 20 may include a filter 22 configured to limit inrush currents, stabilizes voltage levels and suppress electromagnetic interference (EMI). The input power signals 13, once filtered (if employed), are provided to a rectifier or converter 30. The converter 30 is configured to convert the AC power 12 to a DC voltage. The converter 30 may also convert a DC voltage input to a different level DC voltage as may be required in the drive 20. In an embodiment, the converter 30 is active and may be a single or multi-level configuration. The converter 30 could also be a simple passive rectifier, e.g., a diode bridge configured to rectify an AC voltage input to a DC voltage. The output of the converter 30 supplies a DC bus 34. A filter (not shown) may be employed stabilizing the DC bus 34 from transients and to suppress EMI as is conventionally known.

The illustrated drive 20 also includes an inverter 50 to convert the DC voltage on the DC bus 34 to multiphase, AC drive motor command signals 15. Motor command signals 15 from the inverter 50 of the drive system 20 are supplied to a multiphase machine 14. For example, a motor 16 to impart motion to a control surface, power an environmental control system, and the like. In an exemplary embodiment, machine 14 includes, but is not limited to a multiphase, permanent magnet synchronous motor 16. It should also be appreciated, that while the embodiments herein are described primarily with reference to an aircraft electrical system and application, this description is for example only. The embodiments described here are readily applied to any application employing a three phase drive with a multiphase phase sine drive motor power application including motor controls, environmental control, control surface actuation, and any other power system and motor control application.

According to one or more embodiments, both rectifier/converter 30 (if an active type) and inverter 50, are controlled by a controller 60. In an alternative embodiment, converter 30 and inverter 50 may be controlled by separate drive controllers, 60. As stated above controller(s) 60 provides control signals 62 and in to the switching devices of the inverter 50 to control generation of the of the motor command signals 15. Likewise the controller 60 may provide control signals 62 to the active rectifier or converter 30 to control generation and maintenance of the DC voltage on the DC bus 34. Drive controller 60 may be implemented using a general-purpose microprocessor executing a computer program stored on a storage medium to perform the operations described herein. Alternatively, drive controller 60 may be implemented in hardware (e.g., ASIC, FPGA) or in a combination of hardware/software.

In operation, in embodiments employing an active converter 30, the controller 60 develops a DC current command for the converter 30 based on the operation the motor 16 and the inverter 50 generating the motor command signals 15. The DC current command is then employed to formulate the PWM control commands 62 for the switching devices (not shown) of the converter 30 to provide a DC output current to the DC bus 34 accordingly. In addition, the controller 60 receives various input signals or values, including set point signals or values for desired output operation, such as DC bus voltage, motor speed, position, torque, etc., as well as feedback signals or values representing operational values of various portions of the motor drive 20. In another embodiment, a passive rectifier configuration for the converter 30 is employed and no PWM commands from the controller 60 are needed. While such a configuration is advantageous because of its simplicity for employing passive rectifiers to supply the DC bus 34, other configurations with an active converter 30 may be desirable for improved current and electromagnetic interference (EMI) control. Likewise, the controller 60 develops a command for the inverter 50 based on the operation the motor 16 e.g., speed, torque, and the like and the inverter 50 generating the motor command signals 15. The command is then employed to formulate the PWM control commands 64 for the switching devices of the inverter 50 to formulate the motor command signals 15 accordingly.

Conventionally a pulse width modulation (PWM) control scheme is employed to command the switching devices of the converter 30 to supply the DC bus and the inverter 50 to generate and control the motor command signals 15 to the motor 16. Conventionally, such a PWM control scheme employs space vector pulse width modulation SVPWM techniques. Moreover, conventionally the SVPWM for the converter 30 (if active) and inverter 50 would be operated at the same frequency and synchronized. Synchronization of the PWM for both the converter 30 and the inverter 50 improves functions and reduces generated EMI from the operation of the switching devices of the converter 30 and inverter 50).

However, in some applications, other PWM techniques may be employed to address the advantages and constraints imposed by the construction or particular implementation of the converter 30 or inverter 50. For example, conventional discontinuous (DPWM) or even hybrid SVPWM techniques. Hybrid SVPWM is effectively a combination or hybrid of SVPWM and DPWM techniques. Moreover, while it is well known that increasing switching frequency facilitates reductions in the size of magnetics, filters, improves acoustics, and the like, though it does result in increased switching losses in the switching devices for the converter 30 or for the switching devices of the inverter 50. Therefore, in some embodiments, particularly where an active converter 30 is employed it may be advantageous to operate the converter 30 at a different PWM frequency than those of the inverter 50 or with a different PWM scheme than the inverter 50. However, increased operating frequencies also results in increased switching losses in the switching devices reducing efficiency and potentially causing the switching devices to overheat. As a result, while SVPWM is effective for most applications though it is less efficient, employing conventional discontinuous (DPWM) or hybrid SVPWM improves efficiency. Conversely, DPWM or hybrid SVPWM in applications where emitter side current sensing is employed makes current sensing more difficult. Therefore, employing DPWM, or a hybrid SVPWM results improved efficiency at the expense of current sensing quality. Finally, for the inverter 50, in applications where torque/current control are important, low current distortion (and thereby low torque ripple) is commonly desired. As such, continuous SVPWM or hybrid SVPWM techniques are conventionally employed to ensure good motor response. In the embodiments as described herein conventional SVPWM techniques are employed.

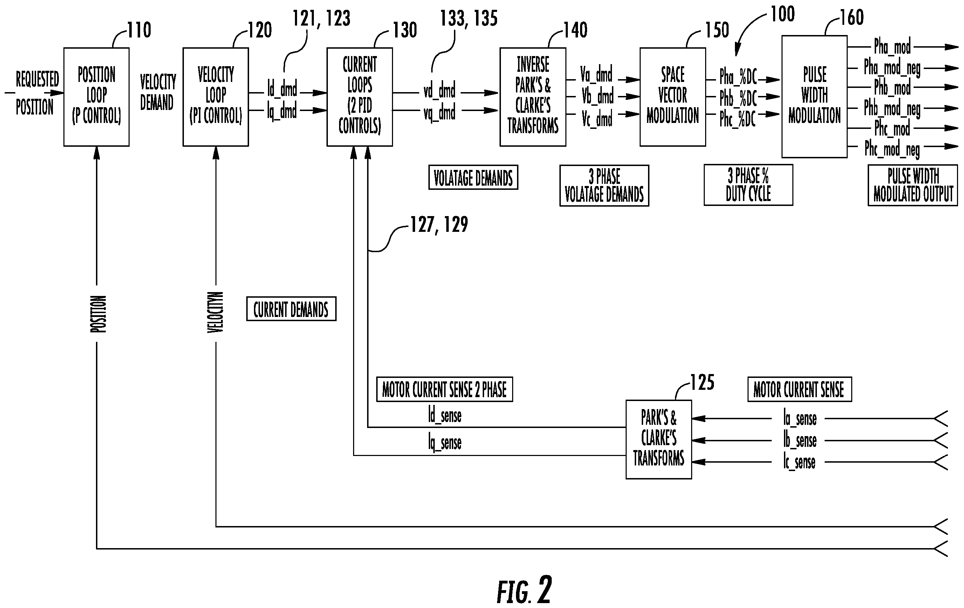

FIG. 2 is an example block diagram of a control process for the power system 10 indicated generally as 100, with a field oriented controlled (FOC) of a permanent magnet synchronous machine (PMSM), e.g., motor 16. Continuing with FIG. 2, the process 100 also includes a motor rotor reference frame current regulation scheme according to an embodiment. The process 100 includes a motor control system employed to control the position, speed, torque, or force of a motor 16. In particular, the process 100 includes conventional position control loop with a position control function 110. The position control function 110 includes a desired/requested position and a position feedback from the motor 16. The position control function 110 formulates a velocity demand as its output. In an embodiment, the position control function 110 is a proportional (P) control process, though in other embodiments other control topologies are possible including proportional-integral (PI) proportional-derivative (PD), and proportional-integral-derivative (PID). In addition, the process 100 includes a conventional velocity control loop with a velocity control function 120 connected to the position control function 110. The velocity control function 120 includes demanded velocity as its input an compares it with the velocity feedback from the motor 16. The velocity control function 120 formulates a direct current demand (Id) and quadrature current demand (Iq) as its output. In an embodiment the velocity control function 120 is proportional-integral (PI) control process, though in other embodiments other control topologies are possible including proportional (P), proportional-derivative (PD), and proportional-integral-derivative (PID).

Continuing with FIG. 2, the process 100 also includes a rotor reference frame current regulation scheme that formulates voltage demand values for the motor 16. In particular the process 100 includes control loops for Id, and Iq and current control function 130 for Id and Iq. The current control function 130 is connected to the velocity control function 120 and includes demanded Id and Iq as its inputs and compares it with Id and Iq feedback respectfully, formulated from sensed phase currents e.g., Ia, Ib, and Ic from the motor 16. In an embodiment, a transform function 125 is employed to convert sensed phase currents, e.g., Ia, Ib, and Ic from the motor 16 to the rotor reference frame. In an embodiment this transform function 125 is a conventional Park's and Clarke's transform, however other transforms may be employed. The current control function 130 formulates a direct voltage demand (Vd) and quadrature voltage demand (Vq) as its output. In an embodiment the current control function 130 is proportional-integral-derivative control process, though in other embodiments other control topologies are possible including proportional, proportional-derivative and proportional-integral. The current control function 130 transmits the two rotor reference frame demand voltages Vd and Vq to a rotor reference frame voltage to phase voltage transformation unit 140. The rotor reference frame voltage to phase voltage transformation unit 140 is operably connected to the current control function 130 and converts the two rotor reference frame voltages Vd and Vq to a phase voltage demands in the form Va, Vb, and Vc. In an embodiment this transform is a conventional inverse Park's and Clarke's transform, however other transforms may be employed. The phase voltage demands Va, Vb, and Vc are supplied to space vector modulation function 150 and then ultimately to the PWM generation function 160. The space vector modulation function 150 is operably connected to the transform function 140 and controls the particular pulse width modulation technique and mapping employed, while the PWM generation function 160 is connected to the space vector modulation function 150 and receives the percentage pulse width commands to controls the width of the pulse or pulse duration, based on modulator signal information in accordance with the selected PWM scheme.

Continuing with FIG. 1, and FIG. 2 as well, the inverter 50 receives the phase voltage modulation demands e.g., control signals 64 from the PWM generation unit 160 and converts the direct current (DC) power into alternating current (AC) power. In this example, the inverter 50 represents a three-phase inverter that converts DC power from the DC bus 34 into three-phase AC power which is provided to the motor 16. The inverter 50 includes any suitable structure for converting power from the DC bus 34 to the AC voltage signals to form phase voltage motor command signals 15 to the motor 16. For example, the inverter 50 could include one or more switches devices (not shown) driven using pulse width modulation (PWM) signals.

The motor 16, in one embodiment, is a permanent magnet motor that operates using the voltages provided by the inverter 50. The motor 16 in a rotary configuration, includes a rotor with magnets embedded in or connected to the rotor. The motor 16 also includes a stator with multiple teeth around which conductive windings are wound. The windings are selectively energized and de-energized based on the signals from the inverter 50, which creates a rotating magnetic field that causes the rotor to rotate. The motor 16 drives a machine 14. The motor 16 can drive the machine 14 with, for example, a drive shaft and one or more gears. Likewise, in linear applications the stator is linearly arranged once again selectively energized and de-energized based on signals from the inverter 50, which causes a translation of forces that moves the secondary.

The position control function 110, velocity control function 120 and current control function 130, the rotor reference frame voltage to phase voltage transformation unit 140, and the PWM generation unit 160 together control the operation of the inverter 50 to thereby control the operation of the motor 16. For example, the PWM generation unit 160 generates PWM signals that drive the transistor switches in the inverter 50. By controlling the duty cycles of the PWM signals, the PWM generation unit 160 controls the three-phase voltages provided by the inverter 50 to the motor 16. For example, in one embodiment, the velocity control function may receive as input a commanded speed signal, which identifies a desired speed of the motor 16. The velocity control function 120 receives as feedback measured or estimated motor speed, optionally rotor position, or other characteristic(s) of the motor 16. The PWM generator 160 uses the inputs to generate PWM signals for driving the transistor switches in the inverter 50.

Although FIG. 1 illustrates one example of a system 100 with a field oriented controlled (FOC) permanent magnet synchronous machine (PMSM), various changes can be made to FIG. 1 without departing from the scope of this disclosure. For example, various components in FIG. 1 can be combined or further subdivided. As a particular example, one or more of the components 110, 120, 130, 140, 150, and 160 could be distributed differently, combined, or even incorporated into the motor 16 itself.

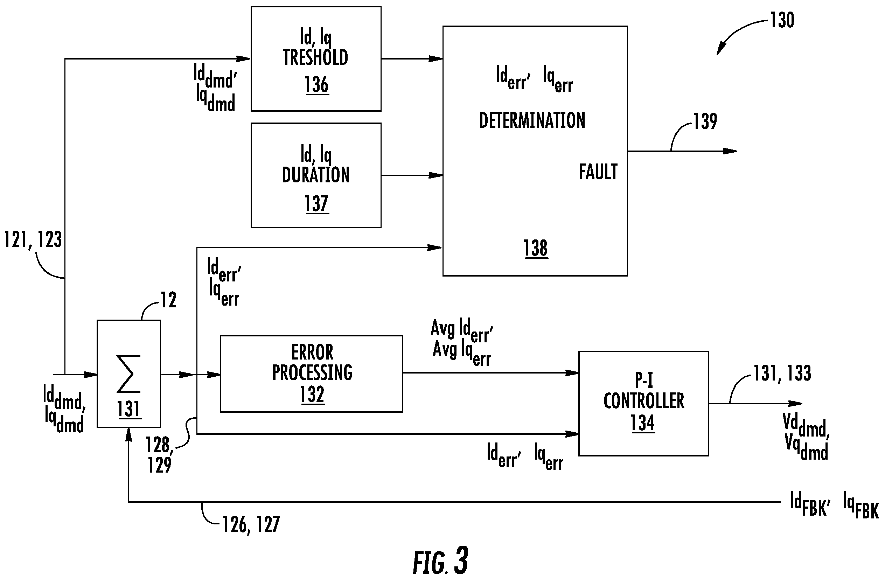

FIG. 3 depicts an expanded view of the current control function 130 in accordance with an embodiment. As described above, the current control function 130 is part of a control loops for the rotor reference frame currents, Id and Iq. For each of the currents Iq and Id, the current control function 130 compares demanded Id and Iq (also denoted with reference numerals 121, 123) with Id feedback and Iq feedback respectively (denoted 126, 127). The comparison formulates a raw Iq and Id error, denoted as signals 128, 129 respectively, as depicted at summation block 131. In an embodiment, the raw Iq and Id error signals 128, 129 are optionally processed and filtered as depicted at error processing function block 132. In an embodiment a filter or persistence function may optionally be employed to formulate an average error signal for Iq and Id.to minimize the impact of noise, transients, perturbations, and the like in the raw error signals. The raw and processed Id and Iq error signals are then directed to controller 134 for formulation of the rotor reference frame demand voltages Vd and Vq denoted 133 and 135, respectively, as described above. The current control function 130 transmits the two rotor reference frame demand voltages Vd and Vq to a rotor reference frame voltage to phase voltage transformation unit 140 (FIG. 2). Once again, though the controller 134 is depicted as a PI controller, it should be appreciated that such depiction is illustrative and other configurations are possible, including, but not limited to proportional-derivative (PD) and proportional-integral-derivative. These errors are directed to a PI(D) controller 134.

In an embodiment, the system 10 also includes a fault detection function 214. The fault determination function 138 detects an existence of a fault in the permanent magnet motor 16 by executing a detection algorithm based on a rotor reference frame current errors 128,129 due to machine imbalance caused by the fault. Advantageously, because the detection is based on the characteristics of the motor rotor reference frame currents, and more specifically the errors, the detection of faults can be made essentially real-time, while the motor 16 is under command and operating. For example, for control purposes, an electric machine e.g., motor 16 is conventionally considered a balanced three phase machine. That is, the total current entering and leaving the phase windings of the motor 16 must sum to zero. An FOC algorithm relies on a balanced machine that is controlled with a balanced set of three phase currents.

Continuing with FIGs 2 and 3, when the Parks and Clarke's transformation is executed, balanced three phase currents in the stator reference frame transform into the two DC like signals (non-sinusoidal) in the rotor reference frame, i.e., Id and Iq. That is, the motor 16 may be commanded to move or may be commanded to a steady state position. In either case, with an unfaulted balanced motor 16, the actual Id and Iq (i.e., the feedback currents) should follow the respective Id and Iq demand currents. In fact, it is expected that under normal balanced operation, the rotor reference frame currents Id_{fbk} and Iq_{fbk} 126,127 would typically track or follow the demanded Id and Iq 121, 123. If a fault exists, e.g., a short in a phase of the motor 16, the three phase currents (stator frame) will be unbalanced during steady state operation and the feedback Iq and Id will no longer produce two DC signals in the rotor reference frame that are in a steady state except at rest. Moreover, because of the deviation resultant from the fault, rotor reference frame currents Id_{fbk} and Iq_{fbk} 126,127, computed in the Parks and Clarke's transform function 125 from the motor phase currents will no longer correspond/follow the demanded Id and Iq 121, 123 as expected with the FOC algorithm. Advantageously, as such, the error signals Iderr and Iqerr 128, 129 will change and exhibit an unexpected deviation. In the described embodiments, the fault detection function 138 is configured to detect and respond to this deviation. In an embodiment, the fault detection function 138 monitors the reference frame current error signals Idₑᵣᵣ and Iqₑᵣᵣ, 128, 129, and determines if a fault exists. The fault detection function 138 compares the rotor reference frame current error signals Idₑᵣᵣ and Iqₑᵣᵣ, 128, 129, each with a selected threshold. A sufficient deviation is indicative of a fault in the motor 16. It should be appreciated that under normal FOC operation the feedback currents e.g., Id_{fbk} and Iq_{fbk} 126, 127 should generally follow the demand currents Id_{dmd} and Iq_{dmd}, 121, 123 at steady state. Further, under dynamic conditions, e.g, changing demand, there will be some transient response as the FOC algorithm and system respond particularly due to the delay and dynamic characteristics of the motor 16. Moreover, as the demanded currents increase in magnitude, the variability of the errors will also increase. As such, in an embodiment, to address this variability, the threshold for the current error signals Idₑᵣᵣ and Iqₑᵣᵣ, 128, 129, is also configured to be variable. The Id, Iq threshold function 136 formulates a variable threshold for the current error signals Idₑᵣᵣ and Iqₑᵣᵣ, 128, 129 as a function of the demand currents Iddmd and Iq_{dmd}, 121, 123. Furthermore, to address the dynamic nature of the FOC algorithm and the response of the system 10 and motor 16, comparison of the current error signals Idₑᵣᵣ and Iqₑᵣᵣ 128, 129 with the variable threshold is also temporal. That is, based on a selected time duration as depicted by Id, Iq duration function 137. The duration values a function of one or more system parameters and may be different for the Idₑᵣᵣ and Iqₑᵣᵣ 128, 129. For example, in an embodiment, the durations are a function of the demand or error currents, their magnitudes, or other system factors such as motor 16 and system dynamics, including, but not limited to the dynamics and response characteristics of the motor. In an embodiment, a fault is determined and indicated to the system 10 if at least one of the current error signals Idₑᵣᵣ and Iqₑᵣᵣ 128, 129 exceeds its respective threshold for more than its selected threshold.

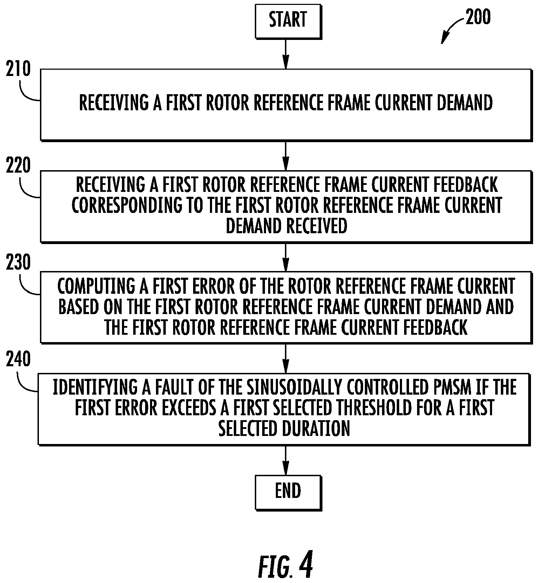

FIG. 4 is a flowchart of a method 200 for detecting faults in a PMSM in accordance with an embodiment. One or more steps of the method may be implemented by controller 60 of the control system 10 as described herein. Moreover, some steps of the method 200 may be implemented as software or algorithms operating on the controller as is conventionally known. The method 200 includes receiving a first rotor reference frame current demand e.g., required/demanded Id or Iq 121,123 as depicted at process step 210. The demand is based on the requirements of operating the motor 16 as described above and is an output of the velocity control function 120 as described above. At process step 220 the method 200 continues with receiving a first and/or second rotor reference frame current feedback e.g., Id_{fbk} and Iq_{fbk} 126, 127 as formulated from the conversion of the sensed phase currents to the rotor reference frame by the Park's and Clarkes transform as depicted at transform function 125. It should be appreciated that the first rotor reference frame current feedback employed in the method corresponds to the first rotor reference frame current demand received. That is, if it is Id demand that is received, then the Id feedback is employed. Further, the method 200 includes computing the error of the rotor reference frame current signals, Idₑᵣᵣ and Iqₑᵣᵣ, 128, 129 based on the current demand and the current feedback as depicted at process step 230 and as described above. Finally, as depicted at process step 240, the method 200 includes identifying a fault of the sinusoidally controlled PMSM if the first error exceeds a selected threshold for a selected duration. Optionally the method may also include receiving a second current demand and feedback and computing a second current error. The second current error may then be compared to a second threshold. Once again, if the second current error exceeds the second threshold for yet another selected duration, a fault of the motor 16 may be indicated. Furthermore the method may optionally include controlling the motor based on the identified fault. The controlling may include operating in a degraded manner if possible (depending on other factors in the system, or if necessary disabling the PMSM.

The terminology used herein is for the purpose of describing particular embodiments only and is not intended to be limiting. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

The present embodiments may be a system, a method, and/or a computer program product at any possible technical detail level of integration. The computer program product may include a computer readable storage medium (or media) having computer readable program instructions thereon for causing a processor to carry out aspects of the present disclosure.

The flowchart and block diagrams in the figures illustrate the architecture, functionality, and operation of possible implementations of systems, methods, and computer program products according to various embodiments. In this regard, each block in the flowchart or block diagrams may represent a module, segment, or portion of instructions, which comprises one or more executable instructions for implementing the specified logical function(s). In some alternative implementations, the functions noted in the blocks may occur out of the order noted in the Figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

While the present disclosure has been described in detail in connection with only a limited number of embodiments, it should be readily understood that the present disclosure is not limited to such disclosed embodiments. Rather, the present disclosure can be modified to incorporate any number of variations, alterations, substitutions, combinations, sub-combinations, or equivalent arrangements not heretofore described, but which are commensurate with the scope of the present invention as defined by the claims.

## Claims

1. A method of detecting a fault in a permanent magnet synchronous motor (PMSM) driven by a sinusoidal input, the having a rotor and operably connected to a controller, the method comprising:
receiving at a controller (60) a first rotor reference frame current demand, the first rotor reference frame current demand based on a current control for the PMSM;
receiving a first rotor reference frame current feedback, the first rotor reference frame current feedback corresponding to the first rotor reference frame current demand received;
computing a first error of the rotor reference frame current based on the first rotor reference frame current demand and the first rotor reference frame current feedback; and
identifying a fault of the PMSM if the first error exceeds a first selected threshold for a first selected duration.

2. The method of claim 1, further comprising:
receiving a second rotor reference frame current demand, the second rotor reference frame current demand based on a current control for the PMSM;
receiving a second rotor reference frame current feedback, the second rotor reference frame current feedback corresponding to the second rotor reference frame current demand received;
computing a second error of the rotor reference frame current based on the second rotor reference frame current demand and the second rotor reference frame current feedback; and
identifying a fault of the sinusoidally driven PMSM if the second error exceeds a second selected threshold for a second selected duration.

3. The method of claim 2, further including identifying a fault of the sinusoidally driven PMSM if the second error exceeds a second selected threshold for a second selected duration.

4. The method of any preceding claim, wherein the first rotor reference frame current demand is the quadrature axis current (Iq).

5. The method of claim 2, 3 or 4 when dependent on claim 2, wherein the second rotor reference frame current demand is the direct axis current (Id).

6. The method of any preceding claim, wherein the first selected threshold is based on at least the first rotor reference frame current demand.

7. The method of claim 6, wherein the first selected threshold is based on a magnitude of the first rotor reference frame current demand.

8. The method of any of claims 1 to 5, wherein the first selected duration is based on at least a characteristic of at least one component of a control system operably connected to the PMSM.

9. The method of claim 2, or any claim dependent thereon, wherein the second selected threshold is based on at least the second rotor reference frame current demand.

10. The method of claim 9, wherein the second selected threshold is based on a magnitude of the second rotor reference frame current demand.

11. The method of claim 2, or any claim dependent thereon, wherein the second selected duration is based on a characteristic of at least one component of a control system operably connected to the PMSM.

12. The method of claim 11, wherein the second selected threshold is based on a dynamic characteristic of the PMSM.

13. The method of any preceding claim, further including controlling the PMSM based on the identifying of a fault of the sinusoidally driven PMSM.

14. The method of any preceding claim, wherein controlling the PMSM based on the identifying of a fault includes disabling the PMSM.

15. A system for detecting a fault in a sinusoidally driven permanent magnet synchronous motor (PMSM), the system comprising:
a sinusoidally driven PMSM (16); and
a controller (60) operably connected to the PMSM, the controller configured to:
receive a first rotor reference frame current demand, the first rotor reference frame current demand based on a current control for the PMSM;
receive a first rotor reference frame current feedback, the first rotor reference frame current feedback corresponding to the first rotor reference frame current demand received;
compute a first error of the rotor reference frame current based on the first rotor reference frame current demand and the first rotor reference frame current feedback; and
identify a fault of the sinusoidally driven PMSM if the first error exceeds a first selected threshold for a first selected duration.
